# EUROPEAN PATENT APPLICATION

(11) **EP 2 416 628 A1**
(43) Date of publication of application: **08.02.2012**
(21) Application number: 10758273.6
(22) Date of filing: 31.03.2010
(51) Int. Cl.: H05B 33/12, H01L 51/50

(54) **ORGANIC ELECTROLUMINESCENT ELEMENT**

(30) Priority: 01.04.2009 JP 2009103381
(71) Applicant: Ason Technology Co., Ltd., Kanagawa 247-0072 (JP)
(72) Inventor: MATSUMOTO, Toshio, Yokohama-shi Kanagawa 231-0005 (JP)
(74) Representative: Gill, Stephen Charles
(86) International application number: PCT/JP2010/002347
(87) International publication number: WO 2010/113493

(57) **Abstract**

Provided is a structure of an organic EL device capable of reducing the product cost by drastically simplifying the fabrication process as compared with a conventional multi-photon organic EL device. An insulating organic material layer having a low dielectric constant is placed to smooth the transfer of electron carriers between a strong electron-accepting material layer and an electron transport layer included in a charge generating layer of the conventional multi-photon organic EL device.

## Description

### Technical Field

The present invention relates to an organic electroluminescent device (hereafter, this may be abbreviated to "organic EL device") to be utilized for a flat surface light source or a display device.

### Background Technology

An organic EL device having a luminescent layer(s) made of an organic compound between opposing anode and cathode is recently attracting attention as one for realizing a large-area display device to be driven at low voltage. Tang et al. from Eastman Kodak Co. adopted a structure to laminate organic compounds with different carrier transportability, and to inject holes and electrons in a balanced manner from the anode and the cathode, for high efficiency of devices, and succeeded to obtain high intensity and high efficiency that are sufficient for a practical application of 1,000 cd/mm² and 1% of external quantum efficiency at 10 V or less of applied voltage.

For example, according to Patent Literature 1 to Patent Literature 6, it is proposed that a device that can produce luminescence at lower applied voltage can be provided by adjusting film thickness of the entire organic layer sandwiched by a cathode and an anode to 1 µm or less, and it is proposed that an electric field (E = Vcm⁻¹) that is useful for obtaining luminescence at 25 V or less of applied voltage can be obtained, preferably if the film thickness is adjusted within the range of 1,000 Å - 5,000 Å.

Although the structure of the organic EL device has been developed on the basis of the structure proposed by Tang et al.; recently, for example, as shown in Patent Literatures 7 and 8, a structure sandwiched by electrodes is regarded as one unit (luminescent unit), and an organic EL device having a structure where a plurality of these luminescent units are laminated so as to enable these luminescent units to be connected in series. This technology is attracting attention as a technology to enable dramatically-longer operating life of the organic EL device, realization of high luminance required for a light source or illumination and uniform light emission of large area. This is because the structure of the organic EL device by Tang et al. requiring a large quantity of current regardless of low voltage cannot satisfy these requirements.

Next, as described in Patent Literature 8, the inventor of the present application invented and realized an organic EL device having a series connected (tandem) type structure, and enabled a series connection of a plurality of luminescent units not by using a transparent electrode material, such as indium tin oxide (ITO) or indium zinc oxide (IZO), but by using an insulating layer made of a charge-transfer complex for a connection layer portion of the units. In this organic EL device, since only an area where a cathode and an anode are crossed produces luminescence as similar to the conventional organic EL device, and, in addition, a sputtering process, which is essential for film formation of the transparent electrode, also becomes unnecessary; at present, this organic EL device is recognized as the most useful among structures of the series structures of the organic EL devices, and it is referred to as a multi-photon organic EL device, and is widely known. The reason why this is referred to as multi-photon is because if the number of luminescent units is the predetermined number or greater, the number of photons exceeding the number of electrons that pass through the organic EL device can be generated (Non-patent Literature 1).

However, this multi-photon organic EL device has a problem where a several times of extra steps become required in manufacturing processes compared to the conventional organic EL device, and in addition, an insulating connection layer made of a charge-transfer complex has to be produced by using a chemical doping technique described in Patent Literatures 9 to 14, i.e., leading to difficulty of controlling the processes when manufacturing the devices.

As described above, the series connected type organic EL device is suitable for producing luminescence with uniform intensity through a large surface area.

In the series connected type organic EL device, compared to the conventional organic EL device, voltage V that is required for obtaining the same luminance can be increased substantially by multiplying by the number of units, and an electric current I can be decreased substantially by being divided by the number of units. As a result, device resistance (a ratio of voltage to electric current: VI⁻¹) is increased by approximately the square of the number of units, and approximately-uniform potential within the surface can be realized like a capacitor where an insulator is sandwiched with electrodes.

Needless to say, the more the number of units is increased, the more uniformity of this potential, i.e., uniformity of luminance is improved. However, according to findings by the inventors of the present application up to now, when luminance at 3,000 cdm⁻² or more necessary for illumination is required, if a luminescent area is approximately 5 inches diagonally, almost-uniform luminescence can be realized with approximately several stacks of units, but if the luminescent area is approximately 15 inches diagonally, it is impossible to uniformly produce luminescence at such high luminance with approximately several stacks of units, and it seems that at least 15 units are required. It is substantially impossible to efficiently produce such many stacks of units at low cost.

The reason why it is impossible to efficiently produce such many stacks of units at low cost primarily lies in a complicated manufacturing method. In other words, as the inventors of the present application have proposed in Patent Literature 8, this is because it is very complicated to produce a charge generating layer placed in order to generate hole carriers and electron carriers.

For example, it is described in claim 1 or 2 of Patent Literature 8 that as if electrons and holes required for excitation of a luminescent material are supplied to a luminescent unit(s) from a charge generating layer consisting of a charge-transfer complex formed by mixing of an electron-accepting material and an electron-donating material or by means of contact due to lamination. However, in actuality, both holes and electrons are supplied to a luminescent material not only by the charge-transfer complex described in Patent Literature 8, but as specifically shown in the examples, at a portion that makes contact with the charge generating layer on the anodic side, a strong electron-donating material, such as alkali metal, certainly affects an (electron -transport) organic material, and electrons (molecules in a radical anion state) have to be generated by radical-anionizing the organic material.

This is because if an electron-transport organic material is not forcibly radical-anionized by the strong electron-donating material, such as alkali metal, molecules in a radical cationic state (holes) that is moved from the anode side toward the luminescent layer happen to reach near by the charge generating layer, and electrons generated within the charge generating layer shall electrically neutralize the molecules in the radical cationic state (holes), without radial-anionizing the electron-transport molecules (this phenomenon may be expressed as "holes migrate toward a cathode").

In this case, needless to say, only the hole move through the luminescent layer containing a luminescent material, and the luminescent layer portion exists only as a resistance for hole current without injecting any electrons (in other words, without producing the luminescent material in a radial-anion state), and the luminescent material does not produce luminescence. In other words, even if"a charge generating layer made of a charge-transfer complex" in Patent Literature 8 is formed and a multi-photon organic EL device is produced, no effect can be obtained in actuality.

As a method for supplying alkali metal into a film, there are a method for directly evaporating alkali metal by resistive heating (resistive heating vapor-deposition technique) and another technique where after a film containing a compound including an alkali metal ion is formed by vapor deposition, an infinitesimal quantity (a quantity equivalent to approximately 15 angstroms of film thickness) of thermal reducing metal, such as aluminum, is supplied also by vapor deposition, and the alkali metal ion is reduced to a metal state, and these methods are proposed in Patent Literature 8.

Further, if an oxide compound, a carbonate compound, a complex oxide compound or a complex carbonate compound containing an alkali metal ion is vapor-deposited using an electron-beam evaporation technique, since the electron-beam evaporation technique itself is one of means to reduce metal in a compound from an ion state to a metallic atom state, as a result, the alkali metal can also affect an electron-transport organic material. In addition, exceptionally, there is also a case that metallic cesium can be produced due to reduction by resistive heating simply in vacuum without using the electron-beam evaporation technique, such as cesium carbonate (CₛCO₃).

For such alkali metal compounds, such as an oxide compound, a carbonate compound, a complex oxide compound or a complex carbonate compound, it is described, for example, in Patent Literature 15 or 16 that an electron-injection layer or a layer referred to as an intermediate cathode layer (interface layer) containing lithium carbonate or lithium oxide is formed so as to make contact with the charge generating layer on the anodic side, and no vapor-deposition technique is specified in these literatures. If a film is formed not by the electron-beam evaporation technique but by a normal resistive heating vapor-deposition technique, because no alkali metal ion in the compound is reduced to metal, it can be easily confirmed that the electron can no longer be transferred to the luminescent material as described above, according to an experiment.

When the alkali metal makes contact with and influences the luminescent organic material of the organic EL device, because luminescence of the luminescent organic material is quenched due to its strong reducing character (this phenomenon may be referred to as luminescence quenching), it is necessary to place the manufacturing chamber for the alkali metal at a location isolated from a manufacturing chamber for forming a layer of an organic material, such as a luminescent layer, in an actual manufacturing process. Therefore, when the organic EL device has to be manufactured by repeating almost the same process over and over like the multi-photon organic EL device having a plurality of luminescent units, it becomes necessary to place a plurality of vapor-deposition chambers and to move back and forth between/among the vapor-deposition chambers; therefore, a process to form a charge generating layer and another layer to make contact with the layer becomes complicated, and there is problem that a product price happens to be increased along with the complication to control individual processes.

Herein, as the electron-donating material other than the alkali metal, a series of organic materials referred to as a leuco base are disclosed, for example, in Patent Literature 17, and there is similarly a demerit in a point that the electron-donating material has a characteristic to reduce a luminescent organic material in any event and its luminescence is quenched.

### PRIOR ART DOCUMENTS

### PATENT LITERATURES

Patent Literature 1: JP Laid-Open Patent Application No. S59-194393
Patent Literature 2: JP Laid-Open Patent Application No. S63-264692
Patent Literature 3: JP Laid-Open Patent Application No. H2-15595
Patent Literature 4: Specification of U.S. Patent No. 4,539,507
Patent Literature 5: Specification of U.S. Patent No. 4,769,292
Patent Literature 6: Specification of U.S. Patent No. 4,885,211
Patent Literature 7: JP Laid-Open Patent Application No. H11-329748
Patent Literature 8: Specification ofJP Patent No. 3,933,591
Patent Literature 9: JP Laid-Open Patent Application No. H10-270171
Patent Literature 10: JP Laid-Open Patent Application No. 2001-102175
Patent Literature 11: JP Laid-Open Patent Application No. H11-233262
Patent Literature 12: JP Laid-Open Patent Application No. 2000-182774
Patent Literature 13: JP Laid-Open Patent Application No. H11-251067
Patent Literature 14: JP Laid-Open Patent Application No. 2001-244079
Patent Literature 15: JP Laid-Open Patent Application No. 2006-135145
Patent Literature 16: JP Laid-Open Patent Application No. 2007-123611
Patent Literature 17: Specification of U.S. Patent No. 7,151,007
**NON-PATENT LITERATURES**

Non-Patent Literature 1: published by Nippon Xypex Co., Ltd.: Organic EL Handbook, "Multi-photon device", p.263-.

### DISCLOSURE OF THE PATENT

### PROBLEM TO BE SOLVED BY THE INVENTION

With regard to the prior arts, the main objective of the present invention is to avoid a use of a reducing material (strong electron-donating material), such as alkali metal, which has been essential to a structure of a multi-photon organic EL device that has been proposed and developed by the inventors of the present application, and therefore, to provide an organic EL device that can exhibit approximately the same performance as the conventional one(s) while the manufacturing process is dramatically simplified. In other words, the main objective of the present invention is to provide an organic EL device without using any radial anionizing means where a strong electron-donating material, such as alkali metal, which has been essential to manufacturing of the conventional multi-photon organic EL devices, is used.

### MEANS FOR SOLVING THE PROBLEM

Thus, the inventors of the present application were dedicated to researching for the purpose of realizing an organic EL device that makes electrons and holes movable toward luminescent layers positioned in anode and cathode directions of charge generating layers, only with an electron-accepting material and an electron-donating material constituting the change generating layer of the organic EL device in Patent Literature 8. As a result, they discovered a structure where electrons (electron-accepting semiconductor molecules in a radical anion state) are moved toward an anode from a charge generation portion without using a strong electron-donating material, such as alkali metal, and that can be injected into the luminescent layers, and they completed the present invention.

In other words, the present invention provides an organic electroluminescent device, including:
an anode;
a cathode;
a plurality of luminescent units containing a luminescent layer positioned between the anode and the cathode, respectively; and
charge generating layers positioned in between the plurality of luminescent units, wherein insulating organic material layers are placed at a portion, where exists a barrier for a movement of carriers from the charge generating layer.

Herein, "charge generating layer" means a layer that plays a role to move electron-donating semiconductor molecules in a radial cation state (holes), and electron-accepting semiconductor molecules in a radial anion state (electrons), which are generated due to donating/accepting electrons between two different semiconductor materials, toward a cathode and an anode, respectively, and to inject them into a luminescent layer existing in the destination direction, respectively, and it contains an electron-accepting material and an electron-donating material.

In the meantime, "charge generating layer" positioned between/among a plurality of luminescent units in the organic EL device of the present invention means a layer that can form a portion where electrons and holes are generated at an interface with an adjacent layer (for example, a hole transport layer), and it does not always have to include both an electron-accepting material and an electron-donating material. For example, in the present invention, "charge generating layer" is made of a strong electron-accepting material (for example, HATCN6), and a hole transport layer that is adjacent at the cathode side of this strong electron-accepting material may be made of an electron-donating material (for example, NPB).

The electron-accepting material and the electron-donating material should be to generate electrons (radical anion) and holes (radical cation) due to donating/accepting of electrons upon volatge application, and they do not have to form a charge-transfer complex in the present invention. Preferably, the electron-accepting material and the electron-donating material that do not form a charge-transfer complex are used in the present invention. Furthermore, the formation of the charge-transfer complex has no relationship with voltage application, but is due to a chemical reaction (oxidation-reduction reaction) between the electron-accepting material and the electron-donating material.

In addition, it is preferable that a material constituting "charge generating layer" in the present invention is all made of organic materials, from a viewpoint of simplicity of manufacturing of the charge generating layer. Therefore, "charge generating layer" in the present invention is preferably made of an organic compound semiconductor.

Next, in the organic EL device of the present invention, "insulating organic material layer" positioned between a charge generating layer and a luminescent layer should be an organic material layer having an insulation property with regard to movement of electron carriers if the carriers are electrons; therefore, it can be made of a hole transport organic material. The hole transport organic material is used normally on the assumption that charges are carried by repeating creation/annihilation of the radical cation state. In the present invention, when the hole transport organic material is used as "insulating organic material" between a charge generating layer and a luminescent layer positioned at the anode side, the hole transport organic material is not radical-cationized, but a radical anion generated in the charge generating layer tunnels through this hole transport organic material, and moves to an electron transport organic material that is adjacent at the anode side. Therefore, in this case, the hole transport organic material exists as simply an insulating organic material without being electrically charged.

Herein, the greatest characteristic of the organic EL device of the present invention is "insulating organic layer" positioned between the charge generating layer and the luminescent layer. An insulating organic material layer in the present invention enables a smooth movement of electrons by physically isolating a strong electron-accepting material existing in the charge generating layer from an electron-transport organic material constituting the electron-transport layer and avoiding an interaction of both (in other words, overlapping of a molecular orbital of the strong electron-accepting material and that of the electron-transport organic material), for example, with the insertion of the insulating organic material layer between the charge generating layer and an electron transport layer existing at its anode side, and the inventors of the present application discovered that undesired potential consumption is reduced in the organic EL device of the present invention, and a desired quantum efficiency (current efficiency) is obtained.

The movement (transit) of carriers within such insulating organic layer of the present invention is, needless to say, due to tunneling current. Therefore, the lower a relative permittivity of the insulating organic material layer becomes, the more preferable it becomes, 5 or less is preferable, 4 or less is more preferable, 3 or less is further more preferable, and 2 or less is further more preferable. If the relative permittivity is 5 or less, because the tunneling current depends upon electric field intensity (V/cm), the thickness of the insulating organic material layer can be, for example, 10 angstroms or greater, and the physical isolation between the strong electron-accepting material in the charge generating layer and the electron-transport organic material in the electron transport layer can be certainly realized. Furthermore, for an insulating inorganic material, many are ones with a relative permittivity exceeding 3 and many are ones that cannot be vapor-deposited by heating.

Furthermore, the insulating organic material layer in the organic EL device of the present invention can be a single film that is made of only an insulating organic material, and it can be a mixed film containing an insulating organic material, an electron-transport organic material to be used for an electron transport layer and/or a strong electron-accepting material to be used for a change generating layer.

### EFFECT OF THE INVENTION

According to the present invention, a use of a reducing material (strong electron-donating material), such as alkali metal, which is essential for a structure of the multi-photon organic EL device that had been conventionally proposed and developed by the inventors of the present application, is avoided; therefore, while its manufacturing process is dramatically simplified, an organic EL device that can exhibit approximately the same performance as the prior art can be provided. Further, according to the present invention, an organic EL device without using a radical anionizing means where a strong electron-donating material, such as alkali metal, which was essential to production of the conventional multi-photon organic EL device, is used can be provided.

To be more specific, according to the present invention, because a formation process for a charge generating layer of the multi-photon organic EL device and its adjacent layer becomes dramatically simplified, and, electrons and holes can be efficiently supplied to a luminescent layer without using any strong electron-donating material, such as alkali metal, for quenching a luminescent organic material, it becomes possible to reduce the number of vapor-deposition chambers, and a process that is beyond control can be eliminated. Consequently, the organic EL device of the present invention can be produced with a process that is dramatically low cost compared to the conventional multi-photon organic EL device.

### BRIEF DESCRIPTION OF DRAWINGS

Fig. 1 is a schematic cross-sectional view showing a typical configuration of an organic EL device of the present invention.
Fig. 2 is a schematic cross-sectional view showing a structure of a test device for evaluating an organic EL device of the present invention produced in Example 1.
Fig. 3 is a graph where current efficiency (cd/A) - current density (mA/cm²) is plotted for the organic EL devices produced in Comparative Examples 1 to 3 and Example 1.
Fig. 4 is a graph where voltage (V)-current density (mA/cm²) is plotted for the organic EL devices produced in Comparative Examples 1 to 3 and Example 1.
Fig. 5 is a graph where current efficiency (cd/A) -current density (mA/cm²) is plotted for the organic EL devices produced in Example 2 and Comparative Example 4.
Fig. 6 is a graph where voltage (V) -current density (mA/cm²) is plotted for the organic EL devices produced in Example 2 and Comparative Example 4.

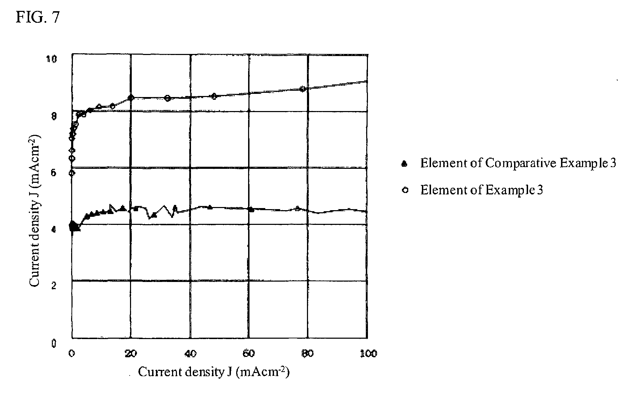

Fig. 7 is a graph where current efficiency (cd/A)-current density (mA/cm²) is plotted for the organic EL device produced in Example 5.

### Best Mode for Carries Out the Invention

The organic EL device of the present invention has an anode; a cathode; a plurality of luminescent units including a luminescent layer positioned between the anode and the cathode, respectively; charge generating layers positioned in between the plurality of luminescent units; and insulating organic material layers placed at a portion, where exists a barrier for a movement of carriers from the charge generating layer. Hereafter, preferred embodiments of the organic EL device relating to the present invention are described in detail. Furthermore, any redundant descriptions may be omitted in the description below.

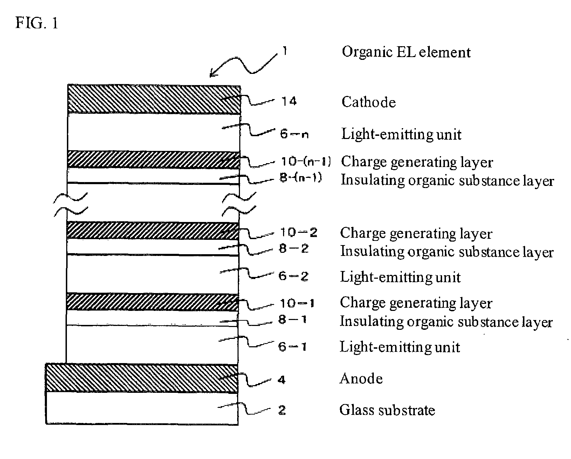

As shown in Fig. 1, an organic EL device 1 of the present invention has a structure that includes *n* luminescent units (n is two or greater integer); and that includes an anode 4, a first luminescent unit 6-1, a first insulating organic material layer 8-1, a first charge generating layer 10-1, a second luminescent unit 6-2, a second insulating organic material layer 8-2, a second charge generating layer 10-2, a (n-1)th insulating organic material layer 8-(n-1), a (n-1)th charge generating layer 10-(n-1), an n-th luminescent unit 6-n and a cathode 14, for example, formed in respective order on a glass substrate 2.

Thus, the organic EL device of the present invention does not at all use any strong electron-donating material, such as alkali metal, which might quench a luminescent organic material constituting a luminescent layer, and has a configuration where low-dielectric insulating organic material layers are placed between the charge generating layer and the luminescent layer in order to efficiently supply electrons into the luminescent layer, respectively.

As "insulating organic material layer" in the organic EL device of the present invention, as described above, it should be made of an insulating organic material with a low relative permittivity, and as such insulating organic material, various organic compounds can be expected to be used. Among them, for example,

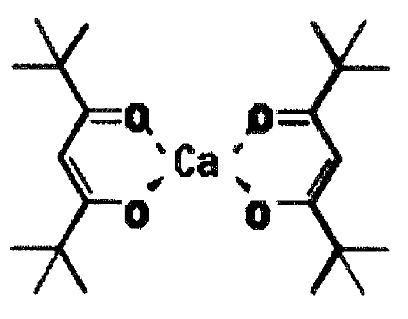

a metallic complex having β diketone type ligand, such as Ca(dpm)₂ (bis-di- pivaloyl-methanate-calcium) expressed with the chemical formula above, can be exemplified.

Further, for example, if being placed at a portion where electrons move, the insulating organic material layer should function as a layer having insulation properties with regard to transport of the electrons; therefore, it can be a hole transport organic material layer formed with a hole transport organic material.

As a material constituting "cathode", in general, metal with a small work function, or, alloy or metal oxide containing the metal is used. Specifically, a metal single body made of alkali metal, such as Li, alkali earth metal, such as Mg or Ca, or rare-earth metal, such as Eu, or, alloy of these metals mixed with Al, Ag or In can be exemplified.

Further, in the case of adopting a configuration using an organic layer that is metal-doped to an interface between a cathode and an organic layer (see JP Laid-Open Patent Application No. H10-270171 or JP Laid-Open Patent Application No. 2001-102175), as along as a cathode is a conductive material, properties, such as its work function, shall not be limited.

When an organic layer making contact with a cathode is made of an organic metal complex compound containing at least one of alkali metal ion, alkali earth metal ion and rare-earth metal ion using the technology disclosed in, for example, JP Laid-Open Patent Application No. H11-233262 or JP Laid-Open Patent Application No. 2000-182774, metal that can reduce the metal ion contained in the complex compound to metal in vacuum, for example, (thermal reducing) metal, such as Al, Zr, Ti or Si, or an alloy containing these metals can be used as a cathode material. Among these, in particular, aluminum that is widely used as a wiring electrode in general is preferable from viewpoints of easiness of vapor deposition, high optical reflectance, and chemical stability.

As a material constituting "anode", there is no particular limitation, and for example, a transparent conductive material, such as indium tin oxide (ITO) or indium zinc oxide (IZO), can be used.

For example, when an ITO film is formed with a sputtering method that does not cause any damage to an organic film using a technique described in JP Laid-Open Patent Application No. 2002-332567, if a metal-doped organic layer described in JP Laid-Open Patent Application No. H10-270171 is used for the electron-injection layer as similar to the case of the cathode formation described above, the transparent conductive material, such as ITO or IZO, can also be used.

Therefore, if both the cathode and the anode are transparentized (since both an organic film and a charge generating layer are also transparent) a transparent luminescent device can also be made, and it is also possible to form an organic EL device with a structure where a light is extracted not from a substrate side but from a film formation surface side by forming the anode with metal and using a transparent electrode for a cathode, i.e., in a reverse deposition sequence to the case of a common organic EL device. Further, regarding the formation order of each layer, it is not always necessary to start from a formation of the anode (film formation), but the formation can start from the cathode.

As "charge generating layer" in the present invention, as described above, any layer that can form a portion where electrons and holes are generated at the interface with an adjacent layer (for example, a hole transport layer) is acceptable. For example, if the charge generating layer is made of a strong electron-accepting material (for example, HATCN6) and the hole transporting layer that is adjacent to the cathode side of this strong electron-accepting material is made of an electron-donating material (for example, NPB), when voltage is applied, the electrons and the holes are generated at the interface between the charge generating layer and the hole transport layer. Herein, no charge-transfer complex is being formed at a non-electric field.

For "luminescent unit" in the present invention, various structures can be adopted as similar to the conventionally-known organic EL device, and for example, it should be configured with a combination with a luminescent layer and the hole transport layer and/or the electron transport layer, and it is possible to adopt various modes as the layer combination.

As "luminescent layer", the conventional luminescent layer used for the conventional organic EL device should be acceptable, and a luminescent material constituting the luminescent layer is not particularly limited, as well, and known materials, such as various fluorescent materials or phosphorescent materials, can be used at will. For example, tris(8-hydroxyquinolinato) aluminum complex (Alq3) expressed with the chemical formula mentioned below 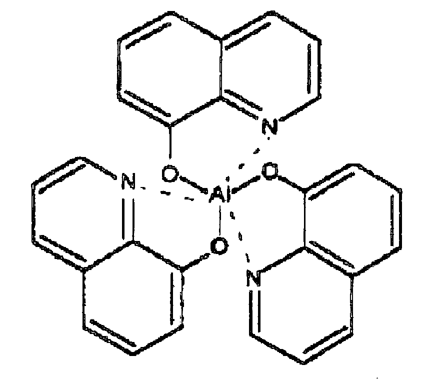 can be exemplified.

"Hole transport layer" should be formed using a hole transport material constituting a hole transport layer in the conventional organic EL device, and there is no particular limitation, and for example, an organic compound (electron-donating material) whose ionization potential is smaller than 5.7 eV, and that has a hole transport property, i.e., an electron-donating property can be exemplified. In general, in order for the organic compound having an electron-donating property to be easily in a radial cation state, it is desired that the ionization potential is smaller than 5.7 eV.

For example, an arylamine compound expressed with a general formula (I):

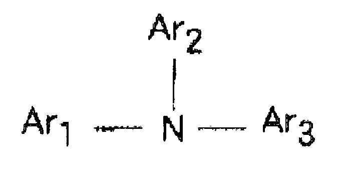

(wherein Ar₁, Ar₂ and Ar₃ represent an aromatic hydrocarbon group that can independently have a substitutent, respectively) is preferable. Among them, 4,4'-bis [N-(2-naphthyl)-N-phenyl-amino] biphenyl (NPB) is preferable.

Further, for "hole transport layer", a pigment-type organic material containing a phthalocyanine compound, which has been conventionally used as a hole injection material of the organic EL device, can be used other than the arylamine compound, and any material that can generate electrons upon voltage application can be appropriately selected and used.

"Electron transport layer " should be formed using an electron-transport material constituting an Electron transport layer of the conventional organic EL device, and there is no particular limitation, but it is preferable to use one having comparatively-deep highest occupied molecular orbital (HOMO) level out of electron-transport materials, which is commonly used for organic EL devices. Specifically, it is preferable to use an electron-transport material having at least basically 6.0 eV or greater HOMO level. When such electron-transport material with comparatively-deep HOMO is used, it is difficult for holes to move the electron-transport material, and as described above, the electrons generated within the charge generating layer can certainly excite a luminescent material and produce luminescence without electrically neutralizing the holes.

Further, it is preferable that a lowest unoccupied molecular orbital (LUMO) level of the electron-transport material used for the present invention is positioned between the LUMO level of the (strong) electron-accepting material used within the charge generating layer and the LUMO level of a luminescent organic material constituting the luminescent organic material. The LUMO level of the strong electron-accepting material is, needless to say, often positioned approximately similar to the HOMO level of the hole transport material, and it is at a deep position even compared to a common organic compound semiconductor, and a difference from the LUMO level of the luminescent organic material is great. Therefore, if the LUMO level of the electron-transport material is located between the LUMO level of the electron-accepting material and the LUMO level of the luminescent organic material, the electron-transport material plays a role as a bridge from a viewpoint of energy, and on the occasion of moving the electrons existing in the LUMO level of the electron-accepting material to the LUMO level of the luminescent organic material, wasteful potential consumption can be reduced, and light emission with high efficiency becomes easier.

Furthermore, as the electron-transport material (organic material), for example, KLET02 manufactured by Chemipro Kasei Kaisha, Ltd. is usable. Furthermore, physical properties of the electron-transport material (organic material) manufactured by Chemipro Kasei Kaisha, Ltd. are as shown below (according to website of Chemipro Kasei Kaisha, Ltd.: http://www.chemipro.co.jp/Yuki#EL/Products.html).

**[Table 1]**

| **Chemipro OLED Materials List** | | | | | | |
|---|---|---|---|---|---|---|
| | Malarial Name | HOMO(eV) | LLMO(eV) | Mobility (cm²/Vs) | Tg(°C) | Td(°C) |
| HIL | KLHI-01 | 4.81 | 1.79 | 3.0×10⁻³ | 102.0 | - |
| HTL | KLHT-01 | 5.55 | 2.53 | 1,4×10⁻⁴ | 96,0 | - |
| | KLHT-03 T1=2.92eV | 5.57 | 2.16 | 1.5×10⁻³ | 106.0 | 445.0 |
| | KLHT-05 | 5.40 | 2.14 | - | 98.0 | 434.0 |
| ETL | Alq3 | 5,93 | 3.22 | 1.0×10⁻⁸ | - | - |
| | KLET-M1 | 5,47 | 2,64 | - | - | - |
| | KLET-01 | 5.93 | 3.07 | - | - | - |
| | KLET-02 T1=2.75eV | 6.75 | 3.22 | 2.5×10⁻⁴ | - | 484.0 |
| | KLET-03 T1=2.56eV | 6.65 | 3.04 | - | - | 470.0 |
| | KLET-10 T1=2,75eV | 6.67 | 2.62 | - | 106.0 | 439.0 |
| (Phosphorescent) | KLMS-01 | 6.10 | 2.66 | - | - | 321.0 |
| | KLHS-02 | 5.90 | 2.40 | - | - | - |
| | KLHS-03 | 5.70 | 2.30 | - | - | - |
| | KLHS-04 T1=2.77eV | 6.10 | 2.84 | Holo3.0×10⁻⁴ Eloct2.0×10⁻³ | 120.0 | 472.0 |
| Dopant | KLDB-01(Blue Fluo) | 5.77 | 2.85 | - | 112.2 | - |
| | Ir delivartives | - | - | - | - | - |
| HBL | KLHB-01 | 5.89 | 2.86 | | - | - |
| | KLHB-02 | 8.49 | 3.01 | - | - | - |

Needless to say, the description: "The LUMO level of the electron-transport material is positioned between the LUMO level of the (strong) electron-accepting material in the charge generating layer and the LUMO level of the luminescent organic material in the luminescent layer" is not an essential constituent of the present invention, but what makes the movement of electron carriers easier is essentially a low-dielectric insulating organic material layer to be intervened between the charge generating layer and the luminescent layer (particularly between the charge generating layer and the Electron transport layer). Furthermore, the LUMO level of the strong electron-accepting material and the HOMO level of the hole transporting material are described, for example, in published Japanese translations of PCT International Publication for Patent Application No. 2007-518220.

Herein, the arylamine compound and the pigment-type organic material (electron-donating material) are often the same materials as the hole transport organic material. When a hole transport layer composed of a hole transport organic material made of the arylamine compound or the pigment-type organic material (electron-donating material) is used, the charge generating layer can be a strong electron-accepting material layer made of a strong electron-accepting material. In this case, electrons and holes are generated at the interface between the hole transport layer in the luminescent unit and the strong electron-accepting material layer as a charge generating layer.

Herein, as the strong electron-accepting material forming the electron-accepting material layer in the present invention, for example,

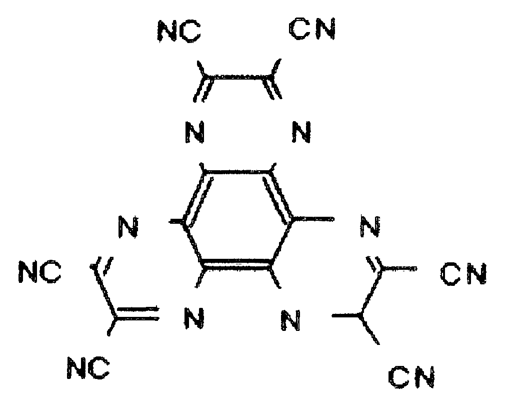

a hexaazatriphenylene derivative (HATCN6) expressed with the chemical formula above is exemplified.

As described above, the embodiment having a typical lamination structure (units) of the organic EL device of the present invention was described, and in the present invention, the design is variously modifiable within the scope of the technical concept of the present invention, and these inventions where the design is modified are also included in the present invention.

Further, in the organic EL device of the present invention, when the electron transport layer is adjacent to the insulating organic material layer, an electron-transport organic material constituting an electron transport layer can be mixed into the insulting organic material layer. In other words, the organic EL device of the present invention may have a mixed layer of an insulating organic material and an electron-transport material, instead of the insulating organic material layer.

Further, in the organic EL device of the present invention, when a strong electron acceptable substance layer is adjacent to the insulating organic material layer, a strong electron-accepting material constituting a strong electron-accepting material layer may be mixed into an insulating organic material layer. In other words, the organic EL device of the present invention may have a mixed layer of an insulating organic material and a strong electron-accepting material, instead of an insulating organic material layer. Even with such configuration, there is a case that an undesirable interaction of the electron-transport material and the strong electron-accepting material can be avoided, and this can be appropriately confirmed with an experiment.

Further, in general, the luminescent layer is composed of a host material and a luminescent material dispersed in the host material in many cases, and there is also a case that the host material is the same material as the electron-transport material. Therefore, in the organic EL device of the present invention, when an electron transport layer is adjacent to the luminescent layer, the luminescent layer and the electron transport layer may be composed of a single layer that is integrally formed using the same material.

Further, in the organic EL device of the present invention, when the hole transport layer is adjacent to the luminescent layer, since the hole transport material may produce luminescence or function as a host material of the luminescent layer, in this case, the luminescent layer and the hole transport layer may be composed of a single layer that is integrally formed. In addition, under this configuration, there is also another case that a luminescent material is dispersed and mixed only in a portion, which is closer to the cathodic side of the hole transport layer.

More specifically, the organic EL device of the present invention, for example, can have the following lamination structure:
a) anode
b) hole injection layer (that may be made of the same material as a charge generating layer)
c) hole transport layer
d) luminescent layer
e) electron transport layer
f) insulating organic material layer
g) charge generating layer
h) repeat of c) to g) above
i) cathode

Further, the organic EL device of the present invention may have the following lamination structure, as well:
a) anode
b) strong electron-accepting material layer
c) hole transport layer
d) luminescent layer
e) electron transport layer
f) insulating organic material layer
g) strong electron-accepting material layer
h) repeat of c) to g) above
i) cathode

The organic EL device of the present invention may have a lamination structure having a mixed layer of the strong electron-accepting material and the hole transport material (strong electron-accepting material : hole transport material) in the lamination structure as described below. Furthermore, it is common that the mixed layer is formed using a technique - co-evaporation - for forming a film by simultaneously heating a plurality of evaporation sources, but the technique shall not be limited to this.
a) anode
b) mixed layer of strong electron-accepting material layer and hole transport material
c) hole transport layer
d) luminescent layer
e) electron transport layer
f) insulating organic material layer
g) mixed layer of strong electron-accepting material layer and hole transport material
h) repeat of c) to g) above
i) cathode

In addition, in the lamination structure, the laminated portion where the electron transport layer is adjacent to the insulating organic material layer ("electron transport layer/ insulating organic material layer") may be changed to a laminated portion ("electron transport layer/ mixed layer of electron-transport organic material and insulating organic material") where the electron transport layer is adjacent to the mixed layer of the electron-transport organic material and the insulating organic material. In other words, the electron-transport organic material forming the electron transport layer may be used by mixing into the insulating organic material layer.

Further, in addition, in the lamination structure, the laminated portion where the electron transport layer is adjacent to the insulating organic material layer ("electron transport layer / insulating organic material layer") may be changed to the laminated portion where the electron transport layer is adjacent to the mixed layer of the insulating organic material and the strong electron-accepting material ("electron transport layer / mixed layer of insulating organic material and strong electron-accepting material"). In other words, the strong electron-accepting material constituting the strong electron-accepting material layer may be used by mixing into the insulating organic material layer. Even with such configuration, there is a case that an undesirable interaction of the electron-transport organic material and the strong electron-accepting material can be avoided, and these can be appropriately confirmed with an experiment.

Further, in general, in the luminescent layer, in many cases, the luminescent material exists by dispersing into a host material, and there is also a case that the host material may be the same as the electron transport material. Therefore, in the organic EL device of the present invention, a laminated portion where the luminescent layer is adjacent to the electron transport layer may be a single layer made of the same material.

Since there are cases that the hole transport material in the lamination structure constitutes a luminescent layer or functions as a host material of the luminescent layer, in these cases, the laminated portion of "hole transport layer/ luminescent layer/ electron transport layer" may be changed to a laminated portion of "hole transport layer (luminescent layer)/ electron transport layer". When a luminescent material is dispersed and mixed only in a portion that is closer to the cathodic side of the hole transport layer, the laminated portion of "hole transport layer/ luminescent layer/ electron transport layer" may be changed to a laminated portion of "hole transport layer/ mixed layer of hole transport material and luminescent material/ electron transport layer".

In other words, in the organic EL device including an anode, a cathode, a plurality of luminescent units that include a luminescent layer and are positioned between the anode and the cathode, respectively, and a charge generating layer(s) positioned between/among the plurality of luminescent units, the organic EL device including a lamination structure where insulating organic material layers are placed at portions where exists a barrier against a movement of charges from the charge generating layer to the luminescent layer, is included in the organic EL device of the present invention.

In the above-mentioned, although the structure of a basic unit of the organic EL device of the present invention was described, the organic EL device of the present invention may have a structure where a plurality of these basic units are laminated. Then, the organic EL device of the present invention can be manufactured with a conventionally-known method using a vacuum deposition device. In particular, when the organic EL device having the configuration where layers other than the anode and the cathode are formed only with organic compounds is obtained, the organic EL device can be manufactured without causing the process to be complicated.

### Examples

Hereafter, the present invention is described in further detail by exemplifying examples, but the present invention shall not be limited to these.

### [Manufacturing device and conditions]

For the formation of an organic compound layers, metallic layers and charge generating layers, a vacuum deposition device manufactured by EIKO Co., Ltd. was used. Thickness of each layer was measured using a stylus-type profilometer (DEKTAK3030), and for characteristic evaluations of the obtained organic EL devices, Source Meter 2400 manufactured by Keithley Instruments Inc. and Luminance Meter BM-7 manufactured by TOPCON Corporation were used. Further, an anode of the organic EL device was formed with ITO and the cathode was formed with Al, DC voltage was applied at a ratio of 0.1 V/ 2sec or 0.5V/2sec in a step manner, and luminance and an electric current value after 1 sec of voltage rise were measured.

### [Structure of produced organic EL device]

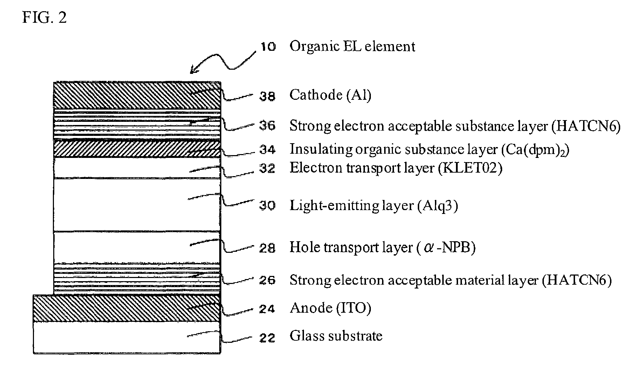

In the present example, an organic EL device 10 having the lamination structure shown in Fig. 2 was produced. In other words, the organic EL device 10 having a structure where an anode 24, a strong electron-accepting material layer 26, a hole transport layer 28, a luminescent layer 30, an electron transport layer 32, an insulating organic substrate layer 34, a strong electron-accepting material layer 36 and a cathode 38 were formed (laminated) on a glass substrate 22 was produced respectively in this order.

Thus, in the present example, the layers that are adjacent to the anode and the cathode were made of the same strong electron-accepting material, respectively. In this structure, the strong electron-accepting material layer that is adjacent to the anode accepts electrons from the hole transport layer that contacts with the strong electron-accepting material layer on the cathodic side and radial-cationizes the hole transport material in the hole transport layer (hole generation), and inversely, the strong electron-accepting material itself in the strong electron-accepting material layer is radial-anionized (anionization). In the meantime, the strong electron-accepting material in the strong electron-accepting material layer that makes contact with the cathode is radical-anionized (anionization) by electrons injected from the cathode.
a) anode
b) strong electron-accepting material layer
c) hole transport layer
d) luminescent layer
e) electron transport layer
f) insulating organic material layer
g) strong electron-accepting material layer
h) cathode

Furthermore, if it is verified that the organic EL device with the configuration above is luminescence-producible with a desired efficiency, for example, a process to produce the basic structure of the organic EL device as mentioned below is repeated, and the organic EL device having the same level of characteristics as the multi-photon organic EL device can be obtained.
a) anode
b) strong electron-accepting material layer
c) luminescent unit: hole transport layer luminescent layer
   electron transport layer
e) insulating organic material layer
f) charge generating layer: strong electron-accepting material layer
g) repeat of c) - f) above
h) cathode

Therefore, in the present example, the organic EL device where layers that are adjacent to the anode and the cathode respectively were made of the same strong electron-accepting material was produced.

### <<Example 1>>

As an organic EL device of Example 1, layers mentioned below were sequentially laminated, and an organic EL device 1 having the structure shown in Fig. 1 was produced. A constituent material and thickness of each layer were as follows:
1) Anode
   Indium tin oxide (ITO), 800 angstroms
2) Strong electron-accepting material layer
   Hexaazatriphenylene derivative (HATCN6), 200 angstroms
3) Hole transport layer
   4,4'-bis [N-(2- naphthyl)-N-phenyl-amino] biphenyl (NPB), 500 angstroms
4) Luminescent layer
   Tris(8-hydroxyquinolinato) aluminum complex (Alq3), 300 angstroms
5) Electron transport layer
   KLET02 manufactured by Chemipro Kasei Kaisha, Ltd., 250 angstroms
6) Insulating organic material layer
   Bis-di-pivaloyl-methanate-calcium (Ca (dpm)₂), 60 angstroms
7) Strong electron-accepting material layer
   Hexaazatriphenylene derivative (HATCN6), 200 angstroms
8) Cathode
   Aluminum, 900 angstroms

### «Comparative Example 1»

As an organic EL device of Comparative Example 1, an organic EL device having a configuration where the following layers were sequentially laminated on a glass substrate was produced:
1) Anode
   Indium tin oxide (ITO), 800 angstroms
2) Strong electron-accepting material layer
   Hexaazatriphenylene layer derivative (HATCN6), 200 angstroms
3) Hole transport layer
   4,4'-bis [N-(2-naphthyl)-N-phenyl-amino] biphenyl (NPB), 500 angstroms
4) Luminescent layer
   Tris(8-hydroxyquinolinato) aluminum complex (Alq3), 500 angstroms
5) Strong electron-accepting material layer
   Hexaazatriphenylene derivative (HATCN6), 200 angstroms
6) Cathode
   Aluminum, 900 angstroms

### «Comparative Example 2»

As an organic EL device of Comparative Example 2, an organic EL device having the configuration where the following layers were sequentially laminated on a glass substrate was produced:
1) Anode
   Indium tin oxide (ITO), 800 angstroms
2) Strong electron-accepting material layer
   Hexaazatriphenylene derivative (HATCN6), 200 angstroms
3) Hole transport layer
   4,4'-bis [N-(2-naphthyl)-N-phenyl-amino] biphenyl (NPB), 500 angstroms
4) Luminescent layer
   Tris(8-hydroxyquinolinato) aluminum complex (Alq3), 300 angstroms
5) Electron transport layer
   KLET02 manufactured by Chemipro Kasei Kaisha, Ltd., 250 angstroms
6) Cathode
   Aluminum, 900 angstroms

### «Comparative Example 3»

As an organic EL device of Comparative Example 3, an organic EL device having a configuration where the following layers were sequentially laminated on a glass substrate (a conventional type standard device using an alkali metal compound and a thermal reducing metal) was produced:
1) Anode
   Indium tin oxide (ITO), 800 angstroms
2) Strong electron-accepting material layer
   Hexaazatriphenylene derivative (HATCN6), 200 angstroms
3) Hole transport layer
   4,4'-bis [N-(2-naphthyl)-N-phenyl-amino] biphenyl (NPB), 500 angstroms
4) Luminescent layer
   Tris(8-hydroxyquinolinato) aluminum complex (Alq3), 300 angstroms
5) Electron transport layer
   KLET02 manufactured by Chemipro Kasei Kaisha, Ltd., 400 angstroms
6) Alkali metal compound layer
   Lithium fluoride (LiF), 10 angstroms
7) Cathode
   Aluminum, 900 angstroms

### Evaluation:

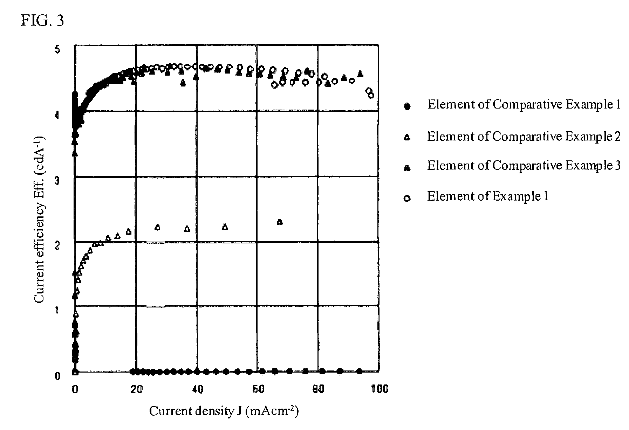

In the organic EL devices produced in Example 1 and Comparative Examples 1 to 3, DC voltage was applied between the anode and the cathode, and various characteristics of green luminescence from the luminescent layer were measured. Herein, a graph where current efficiency (cd/A)-current density (mA/cm²) was plotted is shown in Fig. 2, and a graph where [voltage (V)-current density (mA/cM²)] was plotted is shown in Fig. 3.

As shown in Fig. 3, in the case of the organic EL device of Comparative Example 1, only holes were supplied into the luminescent layer, and no luminescence was produced at all. Further, in the case of the organic EL device of Comparative Example 2, although tentative luminescence was produced by using an electron-transport substance (KLET02) having a deep HOMO level at 6.0 eV or greater for an electron transport layer, compared to the conventional standard device using an alkali metal compound and a thermal reducing metal in Comparative Example 3, approximately 1/2 of current efficiency was merely obtained.

Further, with the organic EL device of Example 1, a high current efficiency was obtained without generating electrons by the alkali metal, because Ca (dpm)₂, which is an insulating organic material, was present, and it became ascertained that it is driven at dramatically low voltage even compared to the organic EL device of Comparative Example 2. .

### «Example 2»

As the organic EL device of Example 2, an organic EL device having the configuration where the following layers were sequentially laminated on a glass substrate was produced:
1) Anode
   Indium tin oxide (ITO), 800 angstroms
2) Strong electron-accepting material layer
   Hexaazatriphenylene derivative (HATCN6), 200 angstroms
3) Hole transport layer
   4,4'-bis [N-(2-naphthyl)-N-phenyl-amino] biphenyl (NPB), 500 angstroms
4) Luminescent layer
   Tris(8-hydroxyquinolinato) aluminum complex (Alq3), 200 angstroms
5) Electron transport layer
   KLET02 manufactured by Chemipro Kasei Kaisha, Ltd., 250 angstroms
6) Insulating organic material layer (hole transport organic material layer; a layer functioning as an insulating layer in an electron transport portion)
   4,4'-bis [N-(2-naphthyl)-N-phenyl-amino] biphenyl (NPB), 60 angstroms
7) Strong electron-accepting material layer
   Hexaazatriphenylene derivative (HATCN6), 50 angstroms
8) Cathode
   Aluminum, 900 angstroms

### «Comparative Example 4»

As the organic EL device of Comparative Example 4, an organic EL device having a configuration where the layers mentioned below were sequentially laminated on a glass substrate was produced. In other words, an organic EL device without an insulating organic material layer of 6) in Example 2 was produced.
1) Anode
   Indium tin oxide (ITO), 800 angstroms
2) Strong electron-accepting material layer
   Hexaazatriphenylene derivative (HATCN6), 200 angstroms
3) Hole transport layer
   4,4'-bis [N-(2-naphthyl)-N-phenyl-amino] biphenyl (NPB), 500 angstroms
4) Luminescent layer
   Tris(8-hydroxyquinolinato) aluminum complex (Alq3), 200 angstroms
5) Electron transport layer
   KLET02 manufactured by Chemipro Kasei Kaisha, Ltd., 250 angstroms
6) Strong electron-accepting material layer
   Hexaazatriphenylene derivative (HATCN6), 50 angstroms
7) Cathode
   Aluminum, 900 angstroms

### Evaluation:

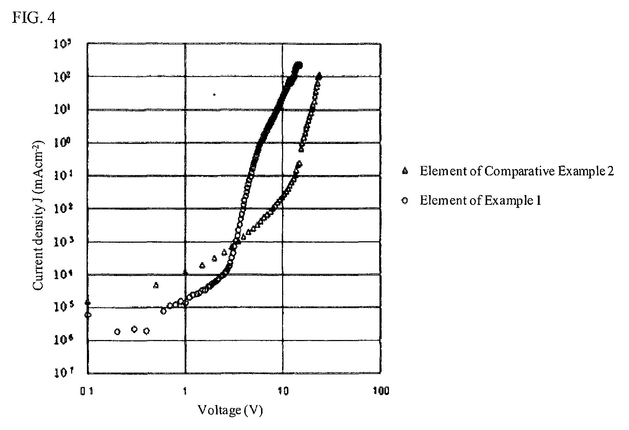

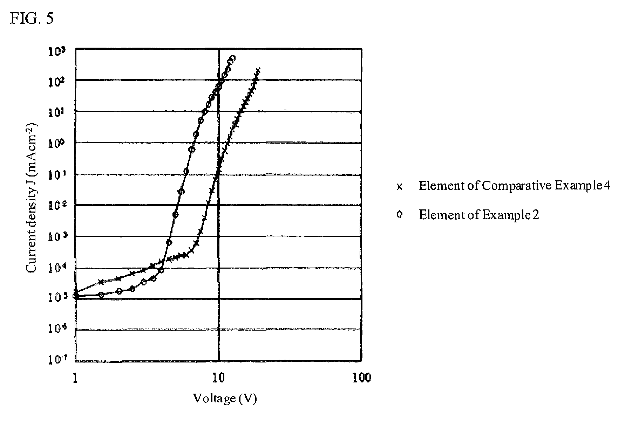

In the organic EL devices produced in Example 2 and Comparative Example 4, DC voltage was applied between the anode and the cathode, and various characteristics of green light emission from the luminescent layer (Alq) were measured. Herein, a graph where current efficiency (cd/A)-current density (mA/cm²) was plotted is shown in Fig. 4, and a graph where [voltage (V) - current density (mA/cm²)] was plotted is shown in Fig. 5.

As shown in Fig. 4, in the case of the organic EL device of Comparative Example 4, tentative luminescence was confirmed, but only a remarkably-low current efficiency was obtained compared to the organic EL device of Example 2. Further, it became ascertained that the organic EL device of Example 2 is driven at dramatically low voltage as similar to the organic EL device of Example 1.

### <<Example 3»

As the organic EL device of Example 3, an organic EL device where the following layer were sequentially laminated on a glass substrate, and that had two luminescent layers, i.e., two luminescent units was produced:
1) Anode
   Indium tin oxide (ITO), 800 angstroms
2) Strong electron-accepting material layer
   Hexaazatriphenylene derivative (HATCN6), 200 angstroms
3) Hole transport layer in first luminescent unit
   4,4'-bis [N-(2-naphthyl)-N-phenyl-amino] biphenyl (NPB), 500 angstroms
4) Luminescent layer in first luminescent unit
   Tris(8-hydroxyquinolinato) aluminum complex (Alq3), 200 angstroms
5) Electron transport layer in first luminescent unit
   KLET02 manufactured by Chemipro Kasei Kaisha, Ltd., 250 angstroms
6) Insulating organic layer (hole transport organic material layer; a layer functioning as an insulating layer in and an electron transport portion)
   4,4'-bis [N-(2-naphthyl)-N-phenyl-amino] biphenyl (NPB), 60 angstroms
7) Strong electron-accepting material layer as charge generating layer Hexaazatriphenylene derivative (HATCN6), 50 angstroms
8) Hole transport organic material layer (1) in second luminescent unit Copper phthalocyanine (CuPc) layer, 100 angstroms
9) Hole transport organic material layer (2) in second luminescent unit 4,4'-bis [N-(2-naphthyl)-N-phenyl-amino] biphenyl (NPB), 600 angstroms
10) Luminescent layer in second luminescent unit
   Tris(8-hydroxyquinolinato) aluminum complex (Alq3), 750 angstroms
11) Alkali metal compound layer as electron-injection layer
   Lithium fluoride (LiF), 10 angstroms
12) Cathode
   Aluminum, 900 angstroms

### Evaluation:

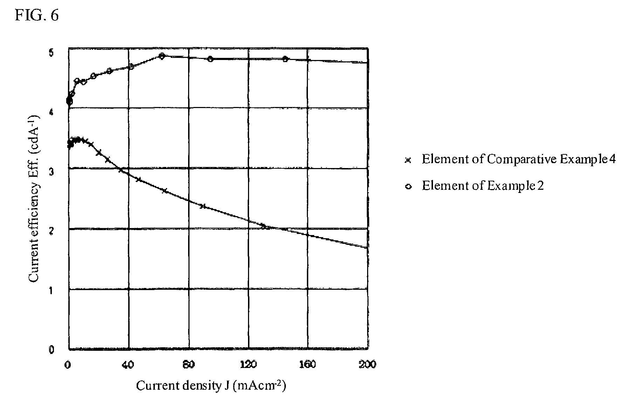

In the organic EL device produced in Example 3, DC voltage was applied between the anode and the cathode, and various characteristics of green luminescence from the luminescent layer (Alq) were measured. Herein, a graph where current efficiency (cd/A)-current density (mA/cm²) was plotted is shown in Fig. 6. As shown in Fig. 6, it became ascertained that approximately two times of current efficiency was obtained with the organic EL device of the present invention having two luminescent layers (luminescent units) in Example 3 compared to the organic EL device in Comparative Example 3 produced as the conventional standard device.

### industrial Applicability

The organic EL device of the present invention is usable in a broad scope of product fields requiring light generation, such as various light sources or image display devices that require low energy consumption.

## Claims

1. An organic electroluminescent device, comprising:
an anode;
a cathode;
a plurality of luminescent units containing a luminescent layer positioned between the anode and the cathode, respectively; and
charge generating layers positioned in between the plurality of luminescent units,
wherein insulating organic material layers are placed at a portion, where exists a barrier against a movement of carriers from the charge generating layer to the luminescent layer, respectively.

2. The organic electroluminescent device according to claim 1, wherein
the insulating organic material layers are placed at a portion, where exists a barrier against a movement of electron carriers from the charge generating layer to the luminescent layer, respectively

3. The organic electroluminescent device according to claim 2, wherein
the insulating organic material layer is a hole transport organic material having an insulating property against electron carriers.

4. The organic electroluminescent device according to any of claims 1 to 3, wherein
a relative permittivity of the insulating organic material layer is 5 or less.

5. The organic electroluminescent device according to any of claims 1 to 4, wherein
the insulating organic material layer comprises an organic metal complex, and a ligand of the organic metallic complex is a β diketone type.

6. The organic electroluminescent device according to any of claims 1 to 6, comprising: an electron transport layer having a hole block property between the insulating organic material layer and the luminescent layer.
